(19) Europäisches Patentamt
European Patent Office
Office européen des brevets

(11) EP 4 632 504 A1

(12) EUROPEAN PATENT APPLICATION

(43) Date of publication:
15.10.2025 Bulletin 2025/42

(51) International Patent Classification (IPC):
G05B 13/02 (2006.01)

(21) Application number: 25163170.1

(22) Date of filing: 12.03.2025

(52) Cooperative Patent Classification (CPC):
G05B 13/0265; G05B 17/02

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 14.03.2024 IN 202421018772

(71) Applicant: Tata Consultancy Services Limited
Maharashtra (IN)

(72) Inventors:
• JADHAV, Vishal Sudam
411006 Pune, Maharashtra (IN)

• DEODHAR, Anirudh
411006 Pune, Maharashtra (IN)
• MAJUMDAR, Ritam
411006 Pune, Maharashtra (IN)
• KARANDE, Shirish Subhash
411006 Pune, Maharashtra (IN)
• RUNKANA, Venkataramana
411006 Pune, Maharashtra (IN)

(74) Representative: Goddar, Heinz J.
Boehmert & Boehmert
Anwaltspartnerschaft mbB
Pettenkoferstrasse 22
80336 München (DE)

(54) **METHOD AND SYSTEM FOR DEVELOPING PRETRAINED MODELS FOR INDUSTRIAL DIGITAL TWINS**

(57) Industrial systems, and equipment are constrained by limited real-time sensor measurements, and monitoring of key performance indicators is difficult which may lead to sub optimal operations of systems. Embodiments of the present disclosure provide a method and system for developing pretrained models for industrial digital twins. A data associated with entity is preprocessed to obtain preprocessed data. The data associated with the entity is mapped with known parameter or unknown parameter of the entity. A n data-driven model is developed based on the identified parameters to select top m models. Top k unknown parameter is selected based on highest value of a parameter attribution score for selected top $m$ model. Estimated value is determined for the top $k$ unknown parameter to develop and iteratively train a physics informed data driven model. A physics-based error and a data-based error must be less than predefined physical discrepancy threshold and data discrepancy threshold.

FIG. 2

EP 4 632 504 A1

**Description**

CROSS-REFERENCE TO RELATED APPLICATIONS AND PRIORITY

The present application claims priority to Indian application no. 202421018772, filed on March 14, 2024

TECHNICAL FIELD

The disclosure herein generally relates to a data analytics, and, more particularly, to a method and system for developing pretrained models for industrial digital twins.

BACKGROUND

Industrial systems, assets, and equipment are constrained by limited real-time sensor measurements, often operating at different time scales. Performance monitoring relies heavily on laboratory and experimental data. Due to the limited real-time sensor measurements, monitoring of key performance indicators (KPI) in real time is difficult which may lead to sub optimal operations of these systems. The acquisition of experimental data is both costly and subject to uncertainty, owing to limited sample sizes, leading to potential errors in predictions and estimations. Additionally, the irregular availability of experimental data compounds these issues. Therefore, to assess the current state of equipment, to enable predictive and prescriptive maintenance, models that capture the underlying physics of the processes in detail are imperative. For developing data-driven models capable of capturing this level of process physics demands an extensive amount of data, a resource often lacking in this context. Furthermore, data-driven models alone fall short in capturing the complete physics of the process, limiting their predictive power and utility.

Further, physics-based models provide a comprehensive representation of the process physics but are hindered by high computational costs and accuracy contingent on numerical methods that are implemented. Their unsuitability for real-time monitoring due to extended simulation and prediction times further limits their practicality. Reduced-order models, designed as substitutes for high-fidelity physics-based models, introduce simplifications that compromise precision during estimation. In response to these challenges, physics-based data-driven models emerge as a remedy to address the computational expenses of physics-based models, the interpretability, and physical consistency shortcomings of purely data-driven models. The physics-based data-driven models permit real-time monitoring, diagnosis, predictive, and prescriptive analyses due to their minimal prediction times. However, developing such models for industrial systems confronts various challenges. Designing the model architecture to achieve good predictive capability, which often requires extensive trial and error. Ensuring that the model captures the necessary physics of the process, however, while validating against experimental/lab measurements, a task that poses convergence challenges. Addressing the difficulty of achieving physical consistency in the models, especially when process parameters are unknown or require tuning. However, most of the times even if the approximate of physics of the process is known, parameters of the process are unknown or their exact formulation for given process needs to be tuned. Due to high number of unknown parameters or their formulations incorporating the physics in the models is tough. Handling challenges related to limited scenarios covered in experimental/sensor measurements, uncertainty and reliability issues in experimental data, and potential errors in sensor measurements, and operational shifts or faults.

In the current landscape, multiple modeling techniques are available, including the physics-based models, the data-driven models, and hybrid models that amalgamate both approaches. Computational intensity of the high-fidelity physics-based models, limited quality, and explication of measurement data, which hinder widespread deployment of data-driven models within industrial settings. Hybrid models, which combine merits of both approaches, offer enhanced comprehensibility and reliability while mitigating computational overhead. However, in industrial contexts, obscurity of the underlying physics often leads to the unavailability of critical parameters, impeding the seamless integration of the physics-based approach with data-driven methods. Furthermore, due to the scarcity and noise in sensor measurements, predicting the parameters of the physics-based approach from data becomes unfeasible. Moreover, the iterative selection and search for a suitable model design for hybrid models to deliver high-fidelity process parameter solutions are complicated by ill-posed nature of physics model definitions and scarcity of high-quality measurement data.

SUMMARY

Embodiments of the present disclosure present technological improvements as solutions to one or more of the above-mentioned technical problems recognized by the inventors in conventional systems. For example, in one aspect, a method of developing one or more pretrained models for industrial digital twins is provided. The processor implemented method includes receiving, via one or more hardware processors, a data associated with one or more entity as an input; preprocessing, via the one or more hardware processors, the data associated with the one or more entity to obtain a preprocessed data; generating, via the one or more hardware processors, a physics-based mathematical formulation ($M$) for the one or more entity; developing, via the one or more hardware processors, one or more n data-driven models using one or more machine learning techniques based on one or more known parameter or one or more unknown parameter to select one or more top m models; selecting, via the one or more hardware processors, one or more top k unknown parameters based on a highest value of a parameter attribution score for the one or more selected top $m$ models; determining, via the one or more hardware processors, an estimated value for the one or more top k unknown parameters using an optimization-based technique; developing, via the one or more hardware processors, one or more physics informed data driven (PIDD) models for each of the one or more selected top m models using the estimated value for the one or more top k unknown parameter; and iteratively training, via the one or more hardware processors, the one or more physics informed data driven (PIDD) models by minimizing a loss function $\mathcal{L}$ , which combines a data-based error ( $\mathcal{L}_{data}(\phi)$) and a physics-based error ($\mathcal{L}_{physics}(\phi)$): (a) iteratively identifying, via the one or more hardware processors, the one or more top k unknown parameter by an inner iteration loop ($iter_k$) in a range of $T_k$ times, if any of the one or more selected top m model does not meet a pre-defined threshold value for the data-based error ($\mathcal{L}_{data}(\phi)$), and the physics-based error ($\mathcal{L}_{physics}(\phi)$), (b) iteratively updating, via the one or more hardware processors, one or more trained physics informed data driven (PIDD) models associated with the one or more top k unknown parameter associated with the one or more entity. The data associated with the one or more entity pertains to (i) a sensor measurement data, (ii) a experimental measurement data, (iii) a design data, and (iv) one or more operational parameters. The one or more entity pertains to a system, or an equipment, or a process. The preprocessed data pertains to a cleaned imputed dataset ($\mathcal{D}_{cleaned}$). The data associated with the one or more entity is mapped with one or more known parameters or one or more unknown parameters of the one or more entity to generate comparison mappings for the one or more entity using a mapping model. The one or more known parameters and the one or more unknown parameters are identified in the physics-based mathematical formulation ($M$) by the comparison mappings generated for the one or more entity. The one or more n data-driven models are trained to obtain one or more trained n data-driven models based on the cleaned imputed dataset ($\mathcal{D}_{cleaned}$). The parameter attribution score is determined based on a degree of deviation or a sensitivity S(p) of a residue of the physics-based mathematical formulation ($M$) for one or more changes in the one or more unknown parameters. The one or more top k unknown parameters are iteratively identified by the inner iteration loop ($iter_k$) in a range of $T_k$ times, if any of the one or more selected top m models does not meet the pre-defined threshold value for the data-based error ($\mathcal{L}_{data}(\phi)$), and the physics-based error ($\mathcal{L}_{physics}(\phi)$). One or more new set of top m models are selected and continued by an outer iteration loop ($iter_m$) until a range of $T_m$ times, if any of the one or more selected top m models does not meet the pre-defined threshold value for the data-based error ($\mathcal{L}_{data}(\phi)$), and the physics-based error ($\mathcal{L}_{physics}(\phi)$) after iteration of the range of the $T_k$ times. The inner iteration loop ($iter_k$) and the outer iteration loop ($iter_m$) is exited, if any of one or more selected top m models meet the pre-defined threshold value for the data-based error ($\mathcal{L}_{data}(\phi)$), and the physics-based error ($\mathcal{L}_{physics}(\phi)$).

In an embodiment, the sensor measurement data pertains to (i) a temperature measurement data, (ii) a pressure measurement data, (iii) a flow measurement data, and (iv) a vibration measurement data. In an embodiment, the experimental measurement data pertains to a property or a quality estimation of a fluid or a solid in processing of the one or more entity. In an embodiment, the data associated with the one or more entity is preprocessed to obtain the preprocessed data, includes: (a) an aggregated dataset (D) is obtained at uniform intervals, (b) the outlier data, and the missing data in the aggregated dataset (D) is imputed to obtain the cleaned imputed dataset ($\mathcal{D}_{cleaned}$). In an embodiment, the aggregated dataset *(D)* include the outlier data and the missing data which are to be identified by (i) a defining threshold method, or (ii) a statistical method, and (iii) one or more imputation methods respectively. In an embodiment, the one or more parameters are marked as the one or more unknown parameters, if the one or more parameters in the physics-based mathematical formulation ($M$) is not present in the comparison mappings generated for the one or more entity using the mapping model. In an embodiment, the physics-based mathematical formulation ($M$) pertains to a set of algebraic equations, or a set of differential equations, or combination thereof. In an embodiment, the one or more trained n data-driven model are ranked based on one or more evaluated model performance metrics. In an embodiment, the one or more evaluated model performance metrics pertains to one or more error metrics. In an embodiment, the one or more error metrics are computed for each n data-driven model $f_i$, and a rank $R_i$ is assigned using one or more ranking methods. In an embodiment, the one or more top m models are selected based on the corresponding ranks $R_i$. In an embodiment, one or more ranges are estimated for the one or more unknown parameters by querying a reference literature and a database. In an embodiment, the sensitivity $S(p)$ is calculated as a partial derivative of a residue with respect to each parameter $p$. In an embodiment, the residue of the physics-based mathematical formulation ($M$) is calculated using one or more data-driven model predictions for each element in a set of parameter combinations ($P\_known$, $P_{unknown}^{sample}$).

In another aspect, there is provided a system for developing one or more pretrained models for industrial digital twins. The system includes a memory storing instructions; one or more communication interfaces; and one or more hardware processors coupled to the memory via the one or more communication interfaces, wherein the one or more hardware processors are configured by the instructions to: receive a data associated with one or more entity as an input; preprocess the data associated with the one or more entity to obtain a preprocessed data; generate a physics-based mathematical formulation ($M$) for the one or more entity; develop one or more n data-driven models using one or more machine learning techniques based on one or more known parameter or one or more unknown parameter to select one or more top m models; select one or more top k unknown parameters based on a highest value of a parameter attribution score for the one or more selected top $m$ models; determine an estimated value for the one or more top k unknown parameters using an optimization-based technique; develop one or more physics informed data driven (PIDD) models for each of the one or more selected top m models using the estimated value for the one or more top k unknown parameter; and iteratively train the one or more physics informed data driven (PIDD) models by minimizing a loss function $\mathcal{L}$, which combines a data-based error ($\mathcal{L}_{data}(\phi)$) and a physics-based error ($\mathcal{L}_{physics}(\phi)$): (a) iteratively identify the one or more top $k$ unknown parameter by an inner iteration loop ($iter_k$) in a range of $T_k$ times, if any of the one or more selected top m model does not meet a pre-defined threshold value for the data-based error ($\mathcal{L}_{data}(\phi)$), and the physics-based error ($\mathcal{L}_{physics}(\phi)$), (b) iteratively update one or more trained physics informed data driven (PIDD) models associated with the one or more top k unknown parameter associated with the one or more entity. The data associated with the one or more entity pertains to (i) a sensor measurement data, (ii) a experimental measurement data, (iii) a design data, and (iv) one or more operational parameters. The one or more entity pertains to a system, or an equipment, or a process. The preprocessed data pertains to a cleaned imputed dataset ($\mathcal{D}_{cleaned}$). The data associated with the one or more entity is mapped with one or more known parameters or one or more unknown parameters of the one or more entity to generate comparison mappings for the one or more entity using a mapping model. The one or more known parameters and the one or more unknown parameters are identified in the physics-based mathematical formulation ($M$) by the comparison mappings generated for the one or more entity. The one or more n data-driven models are trained to obtain one or more trained n data-driven models based on the cleaned imputed dataset ($\mathcal{D}_{cleaned}$). The parameter attribution score is determined based on a degree of deviation or a sensitivity $S(p)$ of a residue of the physics-based mathematical formulation ($M$) for one or more changes in the one or more unknown parameters. The one or more top k unknown parameters are iteratively identified by the inner iteration loop ($iter_k$) in a range of $T_k$ times, if any of the one or more selected top m models does not meet the pre-defined threshold value for the data-based error ($\mathcal{L}_{data}(\phi)$), and the physics-based error ($\mathcal{L}_{physics}(\phi)$). One or more new set of top m models are selected and continued by an outer iteration loop ($iter_m$) until a range of $T_m$ times, if any of the one or more selected top m models does not meet the pre-defined threshold value for the data-based error ($\mathcal{L}_{data}(\phi)$), and the physics-based error ($\mathcal{L}_{physics}(\phi)$) after iteration of the range of the $T_k$ times. The inner iteration loop ($iter_k$) and the outer iteration loop ($iter_m$) is exited, if any of one or more selected top m models meet the pre-defined threshold value for the data-based error ($\mathcal{L}_{data}(\phi)$), and the physics-based error ($\mathcal{L}_{physics}(\phi)$).

In an embodiment, the sensor measurement data pertains to (i) a temperature measurement data, (ii) a pressure measurement data, (iii) a flow measurement data, and (iv) a vibration measurement data. In an embodiment, the experimental measurement data pertains to a property or a quality estimation of a fluid or a solid in processing of the one or more entity. In an embodiment, the data associated with the one or more entity is preprocessed to obtain the preprocessed data, includes: (a) an aggregated dataset (D) is obtained at uniform intervals, (b) the outlier data, and the missing data in the aggregated dataset (D) is imputed to obtain the cleaned imputed dataset ($\mathcal{D}_{cleaned}$). In an embodiment, the aggregated dataset (D) include the outlier data and the missing data which are to be identified by (i) a defining threshold method, or (ii) a statistical method, and (iii) one or more imputation methods respectively. In an embodiment, the one or more parameters are marked as the one or more unknown parameters, if the one or more parameters in the physics-based mathematical formulation ($M$) is not present in the comparison mappings generated for the one or more entity using the mapping model. In an embodiment, the physics-based mathematical formulation ($M$) pertains to a set of algebraic equations, or a set of differential equations, or combination thereof. In an embodiment, the one or more trained n data-driven model are ranked based on one or more evaluated model performance metrics. In an embodiment, the one or more evaluated model performance metrics pertains to one or more error metrics. In an embodiment, the one or more error metrics are computed for each n data-driven model $f_i$, and a rank $R_i$ is assigned using one or more ranking methods. In an embodiment, the one or more top m models are selected based on the corresponding ranks $R_i$. In an embodiment, one or more ranges are estimated for the one or more unknown parameters by querying a reference literature and a database. In an embodiment, the sensitivity $S(p)$ is calculated as a partial derivative of a residue with respect to each parameter $p$. In an embodiment, the residue of the physics-based mathematical formulation ($M$) is calculated using one or more data-driven model predictions for each element in a set of parameter combinations ($P\_known$, $P_{unknown}^{sample}$).

In yet another aspect, a non-transitory computer readable medium for comprising one or more instructions which when executed by one or more hardware processors causes at least one of: receiving, a data associated with one or more entity as an input; preprocessing, the data associated with the one or more entity to obtain a preprocessed data; generating, a physics-based mathematical formulation ($M$) for the one or more entity; developing, one or more n data-driven models using one or more machine learning techniques based on one or more known parameter or one or more unknown parameter to select one or more top m models; selecting, one or more top $k$ unknown parameters based on a highest value of a parameter attribution score for the one or more selected top $m$ models; determining, an estimated value for the one or more top k unknown parameters using an optimization-based technique; developing, or more physics informed data driven (PIDD) models for each of the one or more selected top m models using the estimated value for the one or more top k unknown parameter; and iteratively training, the one or more physics informed data driven (PIDD) models by minimizing a loss function $\mathcal{L}$, which combines a data-based error ($\mathcal{L}_{data}(\phi)$) and a physics-based error ($\mathcal{L}_{physics}(\phi)$): (a) iteratively identifying, the one or more top $k$ unknown parameter by an inner iteration loop ($iter_k$) in a range of $T_k$ times, if any of the one or more selected top m model does not meet a pre-defined threshold value for the data-based error ($\mathcal{L}_{data}(\phi)$), and the physics-based error ($\mathcal{L}_{physics}(\phi)$), (b) iteratively updating, one or more trained physics informed data driven (PIDD) models associated with the one or more top $k$ unknown parameter associated with the one or more entity. The data associated with the one or more entity pertains to (i) a sensor measurement data, (ii) a experimental measurement data, (iii) a design data, and (iv) one or more operational parameters. The one or more entity pertains to a system, or an equipment, or a process. The preprocessed data pertains to a cleaned imputed dataset ($\mathcal{D}_{cleaned}$). The data associated with the one or more entity is mapped with one or more known parameters or one or more unknown parameters of the one or more entity to generate comparison mappings for the one or more entity using a mapping model. The one or more known parameters and the one or more unknown parameters are identified in the physics-based mathematical formulation ($M$) by the comparison mappings generated for the one or more entity. The one or more n data-driven models are trained to obtain one or more trained n data-driven models based on the cleaned imputed dataset ($\mathcal{D}_{cleaned}$). The parameter attribution score is determined based on a degree of deviation or a sensitivity S(p) of a residue of the physics-based mathematical formulation ($M$) for one or more changes in the one or more unknown parameters. The one or more top k unknown parameters are iteratively identified by the inner iteration loop ($iter_k$) in a range of $T_k$ times, if any of the one or more selected top m models does not meet the pre-defined threshold value for the data-based error ($\mathcal{L}_{data}(\phi)$), and the physics-based error ($\mathcal{L}_{physics}(\phi)$). One or more new set of top m models are selected and continued by an outer iteration loop ($iter_m$) until a range of $T_m$ times, if any of the one or more selected top m models does not meet the pre-defined threshold value for the data-based error ($\mathcal{L}_{data}(\phi)$), and the physics-based error ($\mathcal{L}_{physics}(\phi)$) after iteration of the range of the $T_k$ times. The inner iteration loop ($iter_k$) and the outer iteration loop ($iter_m$) is exited, if any of one or more selected top m models meet the pre-defined threshold value for the data-based error ($\mathcal{L}_{data}(\phi)$), and the physics-based error ($\mathcal{L}_{physics}(\phi)$).

In an embodiment, the sensor measurement data pertains to (i) a temperature measurement data, (ii) a pressure measurement data, (iii) a flow measurement data, and (iv) a vibration measurement data. In an embodiment, the experimental measurement data pertains to a property or a quality estimation of a fluid or a solid in processing of the one or more entity. In an embodiment, the data associated with the one or more entity is preprocessed to obtain the preprocessed data, includes: (a) an aggregated dataset (D) is obtained at uniform intervals, (b) the outlier data, and the missing data in the aggregated dataset (D) is imputed to obtain the cleaned imputed dataset ($\mathcal{D}_{cleaned}$). In an embodiment, the aggregated dataset (D) include the outlier data and the missing data which are to be identified by (i) a defining threshold method, or (ii) a statistical method, and (iii) one or more imputation methods respectively. In an embodiment, the one or more parameters are marked as the one or more unknown parameters, if the one or more parameters in the physics-based mathematical formulation (*M*) is not present in the comparison mappings generated for the one or more entity using the mapping model. In an embodiment, the physics-based mathematical formulation (*M*) pertains to a set of algebraic equations, or a set of differential equations, or combination thereof. In an embodiment, the one or more trained n data-driven model are ranked based on one or more evaluated model performance metrics. In an embodiment, the one or more evaluated model performance metrics pertains to one or more error metrics. In an embodiment, the one or more error metrics are computed for each n data-driven model $f_i$, and a rank $R_i$ is assigned using one or more ranking methods. In an embodiment, the one or more top m models are selected based on the corresponding ranks $R_i$. In an embodiment, one or more ranges are estimated for the one or more unknown parameters by querying a reference literature and a database. In an embodiment, the sensitivity $S(p)$ is calculated as a partial derivative of a residue with respect to each parameter p. In an embodiment, the residue of the physics-based mathematical formulation (*M*) is calculated using one or more data-driven model predictions for each element in a set of parameter combinations (P_known, $P_{unknown}^{sample}$).

It is to be understood that both the foregoing general description and the following detailed description are exemplary and explanatory only and are not restrictive of the invention, as claimed.

BRIEF DESCRIPTION OF THE DRAWINGS

The accompanying drawings, which are incorporated in and constitute a part of this disclosure, illustrate exemplary embodiments and, together with the description, serve to explain the disclosed principles:

FIG. 1 illustrates a system to develop one or more pretrained models for industrial digital twins, according to an embodiment of the present disclosure.
FIG. 2 is an exemplary block diagram of the system of FIG. 1 to develop the one or more pretrained models for the industrial digital twins, according to an embodiment of the present disclosure.
FIG. 3A through FIG. 3C are exemplary flow diagrams illustrating a method of developing one or more physics-informed data-driven models for the industrial digital twins, according to an embodiment of the present disclosure.

DETAILED DESCRIPTION OF EMBODIMENTS

Exemplary embodiments are described with reference to the accompanying drawings. In the figures, the left-most digit(s) of a reference number identifies the figure in which the reference number first appears. Wherever convenient, the same reference numbers are used throughout the drawings to refer to the same or like parts. While examples and features of disclosed principles are described herein, modifications, adaptations, and other implementations are possible without departing from the scope of the disclosed embodiments.

There is a need for an efficient approach to address the challenges associated with hybrid model development and difficulty in achieving physical consistency in models, especially when process parameters are unknown or require tuning. Embodiments of the present disclosure provide a method and system for developing pretrained models i.e., one or more physics-informed data-driven models for industrial digital twins. A data associated with one or more entity is received as an input. The data associated with the one or more entity pertains to (i) a sensor measurement data, (ii) an experimental measurement data, (iii) a design data, and (iv) one or more operational parameters. The one or more entity pertains to a system, or an equipment, or a process. The data associated with one or more entity is preprocessed to obtain a preprocessed data, and the preprocessed data pertains to a cleaned imputed dataset ($\mathcal{D}_{cleaned}$). The data associated with one or more entity is mapped with one or more known parameters or one or more unknown parameters of the one or more entity to generate comparison mappings for the one or more entity using a mapping model. A physics-based mathematical formulation (*M*) is generated for the one or more entity. The one or more data-driven models are developed using a machine learning technique based on the one or more identified known parameters or the one or more identified unknown parameters to select one or more top m models. One or more top *k* unknown parameter is selected based on a highest value of a parameter attribution score for each selected top *m* model. The parameter attribution score is determined based on a degree of deviation or a sensitivity $S(p)$ of a residue of the physics-based mathematical formulation (*M*) for one or more changes in the one or more unknown parameters. An estimated value is determined for the top *k* unknown parameter using an optimization-based technique. One or more physics informed data driven (PIDD) models are developed for each of the one or more selected top m models using the estimated value for the one or more top *k* unknown parameters. The one or more physics informed data driven (PIDD) model is iteratively trained by minimizing a loss function $\mathcal{L}$, which combines a data-based error and a physics-based error. The physics-based error and the data-based error must be less than a pre-defined physical discrepancy threshold and a data discrepancy threshold respectively. The one or more trained physics informed data driven (PIDD) models associated with the one or more top k unknown parameters associated with the one or more entity are iteratively updated.

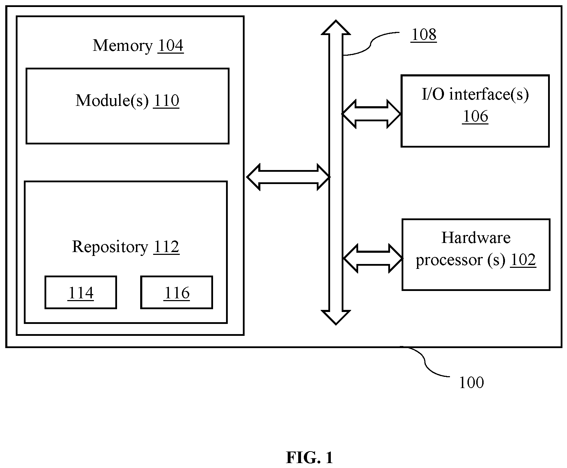

Referring now to the drawings, and more particularly to FIGS. 1 through 3C, where similar reference characters denote corresponding features consistently throughout the figures, there are shown preferred embodiments, and these embodiments are described in the context of the following exemplary system and/or method.

FIG. 1 illustrates a system 100 to develop one or more pretrained models for industrial digital twins, according to an embodiment of the present disclosure. In an embodiment, the system 100 includes one or more processor(s) 102, communication interface device(s) or input/output (I/O) interface(s) 106, and one or more data storage devices or memory 104 operatively coupled to the one or more processors 102. The memory 104 includes a database. The one or more processor(s) processor 102, the memory 104, and the I/O interface(s) 106 may be coupled by a system bus such as a bus 108 or a similar mechanism. The one or more processor(s) 102 that are hardware processors can be implemented as one or more microprocessors, microcomputers, microcontrollers, digital signal processors, central processing units, state machines, logic circuitries, and/or any devices that manipulate signals based on operational instructions. Among other capabilities, the one or more processor(s) 102 is configured to fetch and execute computer-readable instructions stored in the memory 104. In an embodiment, the system 100 can be implemented in a variety of computing systems, such as laptop computers, notebooks, hand-held devices, workstations, mainframe computers, servers, a network cloud, and the like.

The I/O interface device(s) 106 can include a variety of software and hardware interfaces, for example, a web interface, a graphical user interface, and the like. The I/O interface device(s) 106 may include a variety of software and hardware interfaces, for example, interfaces for peripheral device(s), such as a keyboard, a mouse, an external memory, a camera device, and a printer. Further, the I/O interface device(s) 106 may enable the system 100 to communicate with other devices, such as web servers and external databases. The I/O interface device(s) 106 can facilitate multiple communications within a wide variety of networks and protocol types, including wired networks, for example, local area network (LAN), cable, etc., and wireless networks, such as Wireless LAN (WLAN), cellular, or satellite. In an embodiment, the I/O interface device(s) 106 can include one or more ports for connecting number of devices to one another or to another server.

The memory 104 may include any computer-readable medium known in the art including, for example, volatile memory, such as static random-access memory (SRAM) and dynamic random-access memory (DRAM), and/or non-volatile memory, such as read only memory (ROM), erasable programmable ROM, flash memories, hard disks, optical disks, and magnetic tapes. In an embodiment, the memory 104 includes a plurality of modules 110 and a repository 112 for storing data processed, received, and generated by the plurality of modules 110. The plurality of modules 110 may include routines, programs, objects, components, data structures, and so on, which perform particular tasks or implement particular abstract data types.

Further, the database stores information pertaining to inputs fed to the system 100 and/or outputs generated by the system (e.g., data/output generated at each stage of the data processing) 100, specific to the methodology described herein. More specifically, the database stores information being processed at each step of the proposed methodology.

Additionally, the plurality of modules 110 may include programs or coded instructions that supplement applications and functions of the system 100. The repository 112, amongst other things, includes a system database 114 and other data 116. The other data 116 may include data generated as a result of the execution of one or more modules in the plurality of modules 110. Herein, the memory for example the memory 104 and the computer program code configured to, with the hardware processor for example the processor 102, causes the system 100 to perform various functions described herein under.

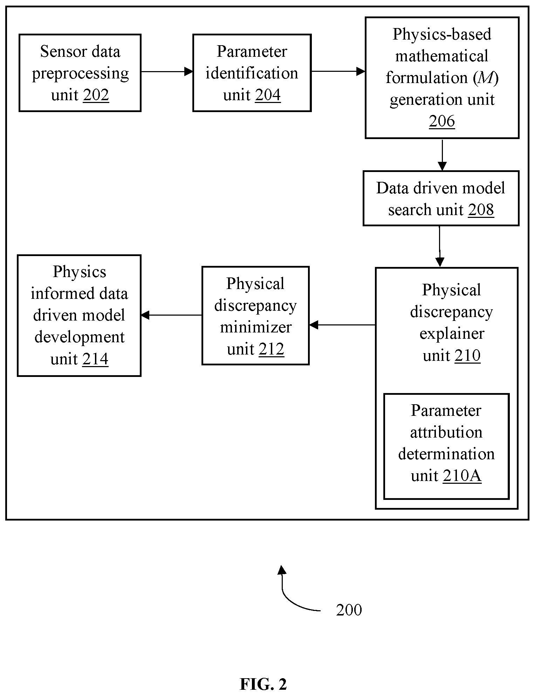

FIG. 2 is an exemplary block diagram of the system 100 of FIG. 1 to develop the one or more pretrained models for the industrial digital twins, according to an embodiment of the present disclosure. A system 200 may be an example of the system 100 (FIG. 1). **In** an example embodiment, the system 200 may be embodied in, or is in direct communication with the system, for example the system 100 (FIG. 1). The system 200 is configured to develop the one or more pretrained models i.e., one or more trained physics-informed data-driven models for the industrial digital twins. The system 200 includes a sensor data preprocessing unit 202, a parameter identification unit 204, a physics-based mathematical formulation (M) generation unit 206, a data driven model search unit 208, a physical discrepancy explainer unit 210, a physical discrepancy minimizer unit 212, and a physics informed data driven model development unit 214. A data associated with one or more entity is received as an input. The data associated with the one or more entity pertains to (i) a sensor measurement data, (ii) an experimental measurement data, (iii) a design data, and (iv) one or more operational parameters. The one or more entity pertains to a system, an equipment, and a process. The sensor measurement data pertains to but is not limited to (i) a temperature measurement data, (ii) a pressure measurement data, (iii) a flow measurement data, and (iv) a vibration measurement data. The sensor measurement data are obtained using one or more physical sensor instruments, and are stored as per design and capacity of the sensor instruments. The experimental measurement data pertains to a property or a quality estimation of fluid or solid in processing of the one or more entity. The measurements are carried out in an experimental laboratory at a predetermined interval. The pre-determined interval herein may pertain to (i) once every eight-hour measurement, or (ii) once everyday measurement intervals, or (iii) similar measurement intervals.

The sensor data preprocessing unit 202 pre-processes the data associated with the one or more entity to obtain a preprocessed data. The preprocessed data pertains to a cleaned imputed dataset ($\mathcal{D}_{cleaned}$). The step of preprocessing of the data associated with the one or more entity includes (a) an aggregated dataset (D) is obtained at uniform intervals, and (b) an outlier data, and a missing data is imputed to obtain the cleaned imputed dataset ($\mathcal{D}_{cleaned}$) based on the aggregated dataset *(D)*. The uniform intervals pertains to measurements recorded per minute, or per hour, or any pre-determined measurement frequency. The parameter identification unit 204 maps the data associated with the one or more entity with one or more known parameters or one or more unknown parameters of the one or more entity using a mapping model.

For example, considering the one or more pretrained models to be developed for a rotary kiln as an equipment which produces materials that require high-temperature treatment. The sensor measurement data and the experimental measurement data are collected as the input which includes the temperature measurement data at various locations along with length of the rotary kiln, and gas composition measurements. The temperature measurement data is represented as mentioned below:

$T_{g\_off\_wall}(x)$: Temperature of gas off a wall at location *x* in Kelvin.
$T_{g\_off\_bed}(x)$: Temperature of gas off a bed at location *x* in Kelvin.
$T_s(x)$: Temperature of the solid bed at location *x* in Kelvin.
$T_w(x)$: Temperature of the kiln wall at location *x* in Kelvin.
x: Position along the kiln length (in meters).

Similarly, the gas composition measurement data is represented as mentioned below:
$C_i(t)$: Concentration of component i in a gas phase at time *t*.
Components: $N_2$, $O_2$, *Ar*, $CO_2$, *Ne, He*, $CH_4$, *Kr*.
*t*: Time in hours.

The temperature measurement data is spatially distributed along the length of the rotary kiln's, recorded by a temperature measurement sensor at time interval of 1 min and stored in the database, and the gas composition measurement data is temporally distributed, recorded at specific time intervals of every 8 hours with experimental sample analysis. In an embodiment, location of the temperature measurement sensor is captured in a piping and instrumentation diagram (P&ID) of the rotary kiln. A mapping of the sensor measurement data and corresponding location are created using the mapping model. The mapping model considers input image of the P&ID diagram and a sensor measurement schema as an input to create the mapping for the sensor measurement data and the corresponding location as an output. The mapping model can be a pre-trained multimodal model which take input in an image and a text format. The mapping model return a parameter list associated with the equipment that is measured and corresponding measurement sensor ids. The parameter list pertains to type, design capacity, dimensions, material, material physical, and chemical properties, and setpoint of operation. The parameter list may be in a string format.

The temperature measurement data and the gas composition measurement data are recorded at different time intervals and are aggregated to analyze performance of the rotary kiln. A common time interval is chosen for aggregation. e.g., a 15-minute interval is proposed. For the temperature measurement data, which is more frequent, are interpolated or extrapolated to match the 15-minute intervals. Similarly, for the gas composition measurement data, which is less frequent, summarize the data over each of 15-minute interval.

Let $\mathcal{T}$ be the set of all temperature measurement types (i.e., $T_{g\_off\_wall}$, $T_{g\_off\_bed}$, $T_s$, $T_w$).
Let *C* be the set of all gas composition components (i.e., $N_2$, $O_2$, *Ar*, $CO_2$, *Ne, He*, $CH_4$, *Kr*).
$t_{temp}$: Original time interval for temperature measurements (1 min).
$t_{gas}$: Original time interval for gas composition measurements (8 hours).
$t_{agg}$: Aggregated time interval (15 min).

$n_{agg}$: Number of original intervals in one aggregated interval $\left(\dfrac{t_{agg}}{t_{temp}}\right)$ for temperature and $\left(\dfrac{t_{agg}}{t_{gas}}\right)$ for gas composition.

An aggregated temperature measurement data model is obtained. Consider, for each measurement type $T \in \mathcal{T}$, and at each location *x,* the aggregated temperature measurement data model $\overline{T}(x , t_{agg})$ is calculated as:

$$\bar{T}(x, t_{agg}) \;=\; \left\{ \frac{1}{n_{agg}} \right\} \sum T(x, t_j)$$

Where $t_j$ are time points within the aggregated interval $t_{agg}$.

An aggregated gas composition measurement data model is obtained. Consider, for each component $C \in \mathcal{C}$, an aggregated composition $\bar{C}(t_{agg})$ over an interval $t_{agg}$ is approximated as:

$$\bar{C}(t_{agg}) \;=\; C(t)$$

Where $t$ is a closest time point to $t_{agg}$ within the 8-hour measurement interval.

A model is inputted with (a) a time series of the temperature measurement data at different locations along the rotary kiln, recorded every minute, and (b) a time series of gas composition measurement data, recorded every 8 hours respectively to obtain the aggregated dataset (D) i.e., (i) an aggregated temperature measurement data averaged over 15-minute intervals, and (ii) an aggregated gas composition measurement data summarized to align with the 15-minute intervals respectively. The aggregated dataset (D) may include the outlier data and the missing data which are identified by defining threshold or a statistical method, and one or more imputation methods respectively.

An outlier detection model is generated by implementing the statistical method or an interquartile range (IQR) method. The statistical method is implemented to identify the outlier data in the aggregated dataset (D) by computing a mean ($\mu$) and a standard deviation ($\sigma$) of the aggregated dataset (D). An outlier threshold is defined as e.g., data points outside $\mu \pm k\sigma$ are considered outliers, where $k$ is a predefined constant. The outlier data identified by the statistical method are as depicted below:

$$\mathcal{O} \;=\; \{ d_i \in \mathcal{D} : d_i < \mu - k\sigma \ \text{or} \ d_i > \mu + k\sigma \}$$

Where $\mathcal{O}$ : Set of identified outliers,
$d_i$: A single data point in the D.
$M$: Set of missing data.

The interquartile range (IQR) method is implemented to identify the outlier data in the aggregated dataset (D). The outlier data is identified by calculating a first quartile (Q1) and a third quartile (Q3) of the D,

$$\text{IQR} = \text{Q3 - Q1},$$

The outlier threshold is defined as data points outside i.e., *[Q1 - k × IQR, Q3 + k × IQR]*.

$$\mathcal{O} \;=\; \{ d_i \in \mathcal{D} : d_i < Q1 - k \times IQR \ or \ d_i > Q3 + k \times IQR \}$$

The identification of missing data is represented as mentioned below:

$$\mathcal{M} \;=\; \{ d_i \in \mathcal{D} : d_i \ is \ missing \}.$$

An imputation model is generated by one or more methods but is not limited to a mean or median imputation method, an interpolation method, and a machine learning-based imputation method. In the mean or median imputation approach, the missing data, or the outlier data are replaced with a mean or median of the aggregated dataset (D).

$$d_i^{imputed} \;=\; mean(\mathcal{D}) \ or \ median(\mathcal{D}) \, for \ d_i \in \mathcal{M} \cup \mathcal{O}$$

In the interpolation method, considering a time-series data, a linear or a spline interpolation are used to estimate missing data based on neighboring data points. The aggregated dataset (D) is considered as an input to obtain the cleaned imputed dataset ($\mathcal{D}_{cleaned}$ ) or the imputed model i.e., each missing data or outlier data, the $d_i$ is replaced with the $d_i^{imputed}$ .

The physics-based mathematical formulation (M) generation unit 206 generates a physics-based mathematical formulation (*M*) for the one or more entity. The parameter identification unit 204 includes a text retrieval model which retrieves the physics-based mathematical formulation (*M*) available in a text or a document which are stored in the database. In an embodiment, one or more large language models (LLMs) are implemented by appropriate query to generate the physics-based mathematical formulation (*M*). The parameter identification unit 204 identifies one or more parameters in the physics-based mathematical formulation (*M*) by comparison mappings generated for the one or more entity. The one or more parameters pertains to one or more known parameters, or one or more unknown parameters. The one or more parameters are marked as the one or more unknown parameters, if the one or more parameters in the physics-based mathematical formulation (*M*) is not present in the comparison mappings generated for the one or more entity using the mapping model.

For example, considering the one or more pretrained models to be developed for the rotary kiln. The physics-based mathematical formulation (*M*) which is generated includes a set of algebraic equations, or a set of differential equations, or a combination thereof. The physics-based mathematical formulation is represented as mentioned below:

$$M = F(Context)$$

where F represents function that generates the physics-based mathematical formulation (*M*) based on the given process context, *Context. F* herein can be rule based programs or artificial intelligence (AI), i.e., the one or more large language models (LLMs) or a deep learning-based model. The context pertains to a process description and an operational context of the process which is inputted to the model to obtain the set of algebraic or the set of differential equations describing the process. The physics-based mathematical formulation (*M*) is considered as an input to identify a source for one or more model parameters i.e., one or more plant design documents, a maintenance history, and a research literature. The one or more known parameters or the one or more unknown parameter are identified using the mapping model based on the physics-based mathematical formulation (*M*) for the one or more entity.

P: Set of parameters required for the physics-based mathematical formulation (M),

$$P = \{p_1, p_2, \ldots, p_n\}.$$

S: Set of sources for information,
$S = \{s_1(plant\ design),\ s_2(maintenance\ history),\ s_3(literature)\}$
$Q(p, s)$: Query function for parameter p and source s.

The one or more parameters in the M is identified and categorized based on availability in the S.

For parameters with known values:

$$P_{known} = \{(p_i, v_i) | p_i \in P, v_i\ is\ the\ value\}.$$

For parameters without known values:

$$P_{unknown} = \{p_i | p_i \in P, p_i\ value\ is\ not\ in\ S\}.$$

One or more query functions are generated for the $P_{unknown}$ using $Q(p,S)$.

For example, a sample implementation for heat transfer in the rotary Kiln used in the cement industry is considered. The documents required as an input are plant design specification document, a kiln design specification document, a maintenance history document/database, operational settings/control guideline document. The sample model output is (a) the set of differential equations representing heat transfer dynamics within the rotary kiln, and (b) the one or more parameters i.e., (i) the one or more known parameters e.g., Kiln dimensions, material thermal properties from plant design specifications and the mapping obtained using the mapping model, (ii) the one or more unknown parameters e.g., queries generated for specific heat transfer coefficients, emissivity values (requiring research in literature).

The data driven model search unit 208 develops one or more data-driven models i.e., n data-driven models using one or more machine learning techniques based on the one or more identified known parameters or the one or more identified unknown parameters (i.e., one or more neural networks with varying architectures and varying parameters) to select one or more top m models. The one or more neural networks with varying architectures pertains to but is not limited to a deep neural network (DNNs), a convolutional neural network (CNNs), a recurrent neural network (RNNs). The varying

parameters $P_i$ pertains to number of layers, neurons per layer, types of activation functions, for each model. In an embodiment, a supervised learning algorithm is implemented to train each n data-driven model to obtain one or more trained n data-driven models based on the cleaned imputed dataset ($\mathcal{D}_{cleaned}$), and an error metrics is calculated. The one or more trained n data-driven models are ranked based on one or more evaluated model performance metrics. The one or more evaluated model performance metrics pertains to the one or more error metrics. The one or more error metrics are computed for each n data-driven model and a rank is assigned using the one or more ranking methods. The one or more top m models are selected based on the corresponding ranks.

For example, the n data-driven models are developed based on variations of the DNN by considering one or more temperature predictions ($T_g$, $T_s$, $T_w$, $T_{sh}$) of the rotary kiln. A model structure for $i^{th}$ DNN Model includes: (i) an input layer which receives a sensor location (X); (ii) hidden layers i.e., multiple layers, each with the varying number of neurons, e.g., $P_i$ specify $L_i$ hidden layers with $N_{ij}$ neurons in $j^{th}$ layer; (iii) activation functions i.e., each layer may use different activation functions, e.g., a rectified linear unit (ReLU), a Sigmoid, or a Tanh; and (iv) output layer which produces a vector $Y_i = [T_{gi}, T_{si}, T_{wi}, T_{shi}]$, representing the predicted temperatures.

n: Number of DNN models.
$X$: Input data (i.e., the sensor location).
$Y$: output prediction (i.e., the sensor measurements: $T_g$, $T_s$, $T_w$, $T_{sp}$).
$f_i$: Function of the $i^{th}$ DNN model.
$P_i$: Parameter set for the $i^{th}$ model.

There are one or more variations in DNN Architectures (a) a grouped network i.e., sub-networks where each predicts a subset of outputs e.g., one sub-network for [$T_g$, $T_s$] and another for [$T_w$, $T_{sh}$]; (b) a sequential network: i.e., multiple sub-networks where output of one is passed as an input to the next, along with the sensor location. Each sub-network predicts one temperature component, e.g., first sub-network predicts $T_g$, the second uses the prediction and $X$ to predict $T_s$.

For example, a mathematical formulation for training and evaluation for n deep neural networks for a rotary kiln heat transfer model is considered. The input considered is n DNN models with varying architectures and the parameters $P_i$. During the training phase, each model $f_i$ is trained using the supervised learning algorithm on the cleaned imputed dataset ($\mathcal{D}_{cleaned}$) containing $X$ and $Y$. The models are ranked based on one or more error metrics e.g., a Root Mean Squared Error (RMSE), a Mean Absolute Error (MAE), and a Mean Absolute Percentage Error (MAPE). For each metric, models are ordered from a lowest score to a highest score. Error metrics is derived from

$$RMSE\left(Y, \widehat{Y_i}\right) = \sqrt{\left\{\frac{1}{N}\sum_j \left(Y_j - Y_{ij}\right)^2\right\}}$$

$$MAE\}\left(Y, \widehat{Y_i}\right) = \frac{1}{N}\sum_j |Y_j - \widehat{Y_{iJ}}|$$

$$MAPE(Y, Y_i) = \frac{100}{N}\sum_j \left|\frac{Y_j - \widehat{Y_{iJ}}}{Y_j}\right|$$

The models are ranked also by (i) a composite score ranking, (ii) a Pareto ranking, (iii) a cross-validation ranking. The composite score ranking in which a composite score is developed by combining the RMSE, the MAE, and the MAPE. For example, a weighted average of three metrics are used, where weights reflect importance of each metric in the specific context. The Pareto ranking in which models are ranked based on multiple metrics simultaneously. A model is considered Pareto optimal if no other model performs better in all the metrics which results in a set of top-performing models, each optimal in different aspects. The cross-validation ranking use a cross-validation to evaluate each model's performance. The models are ranked based on the average performance across different folds.

The one or more error metrics are computed for each model $f_i$, and a rank $R_i$ is assigned based on the chosen ranking method. The one or more top 'm' models are selected based on the corresponding ranks $R_i$.

*N*: Number of data points.

*Y*: True values of sensor measurements.

$Y_i$: Predicted values from the $i^{th}$ model.

*m*: Number of top-performing models to select.

$R_i$: Ranking of the $i^{th}$ model.

The accurate prediction of the physics-based mathematical formulation (*M*) hinges on estimation of the one or more unknown parameters. A subset of unknown parameter from the one or more unknown parameters is determined by a parameter attribution score, which is derived from a degree of deviation between the predictions of the n data-driven models and the physics-based mathematical formulation (*M*). The physical discrepancy explainer unit 210 estimates one or more ranges for unknown parameters by querying a reference literature and a database. The reference literature may include research papers or book on topic of equipment/system mathematical formulation. The databases include one or more material properties database, empirical relations database.

For each $p \in P_{unknown}$, query literature and databases to estimate $R(p)$.

$R(p) = Query(P_{unknown}, Literature \ and \ Databases)$.

Where $P_{unknown}$ is a set of unknown parameters, and $R(p)$ is an estimated range for parameter $p$.

For each $p \in P_{unknown}$, sample values within the range $R(p)$. For example, Monte Carlo or Latin Hypercube Sampling can be used for efficient exploration of a parameter space. A set of parameter combinations (*P_known,* $P^{sample}_{unknown}$) are generated.

The physical discrepancy explainer unit 210 includes a parameter attribution determination unit 210A which determines the parameter attribution score based on a degree of deviation or a sensitivity S(p) of a residue of the physics-based mathematical formulation (*M*) for one or more changes in the one or more unknown parameters. The residue of the physics-based mathematical formulation (*M*) is calculated using the n data-driven models prediction for each element in the set of parameter combinations (*P_known,* $P^{sample}_{unknown}$). For example, the residue is computed for each combination: *Residue*($P_{known}, P_{unknown}, \hat{Y}_i$): Residue function evaluated for the physics-based mathematical formulation (*M*) with the n data-driven model predictions.

The sensitivity *S*(p) is calculated as a partial derivative of the residue with respect to each parameter *p*. The sensitivity *S*(p) measures how changes in *p* affect the discrepancy between the physics-based mathematical formulation (*M*) and the n data-driven models:

$$S(p) = \frac{\partial Residue(P_{known}, P^{sample}_{unknown}, \hat{Y}_i)}{\partial p} \ .$$

Where *S*(p): Sensitivity of the residue with respect to parameter *p*.

$P_{known}$: Set of known parameters.

$P_{unknown}$: Set of unknown parameters.

$R(p)$ : Range for each unknown parameter *p*.

$\hat{Y}_i$: Prediction from the $i^{th}$ data-driven model.

The previously calculated sensitivity values *S*(p) for each parameter $p \in P_{unknown}$. The score for parameters in $P_{unknown}$ is assigned based on corresponding sensitivity value *S*(p) in a descending order. The physical discrepancy explainer unit 210 selects one or more top *k* unknown parameters based on a highest value of the parameter attribution score for the one or more selected top *m* models. For example, the mathematical formulation is mentioned as below:

$$P_{top\_k} = \text{Top } k \text{ elements from sorted } \{S(p)|p \in P_{unknown}\}.$$

Where *k:* The number of top parameters to be selected, and $P_{top\_k}$: Set of top *k* unknown parameters based on sensitivity.

The physical discrepancy minimizer unit 212 determine an estimated value for the one or more top *k* unknown parameters using an optimization-based technique. The optimization-based technique pertains to a particle swarm optimization technique, or a genetic technique, or an expectation maximization technique. An objective function (*ObjectiveFunction*($\theta$)) is constructed, which measures the discrepancy between the physics-based mathematical formulation (*M*) and the n data-driven models using both known parameters and estimated values of $P_{top\_k}$.

*ObjectiveFunction*($\theta$): Function quantifying the discrepancy for the physics-based mathematical formulation *M* calculated using the n data-driven model predictions is same as the *Residue*($P_{known}$, $P_{unknown}$, $\hat{Y}_i$) used in the parameter attribution determination unit 210A. Note $P_{top\_k}$ is subset of $P_{unknown}$.

Where $P_{top\_k}$: Set of top k unknown parameters selected based on parameter attribution determination unit output.

$\theta$: Vector representing the values of parameters in $P_{top\_k}$.

The optimization-based technique iteratively adjusts the $\theta$ to find an optimal set of parameter values $\theta_{opt}$, thereby the discrepancy (*ObjectiveFunction*($\theta$)) is minimized.

Where $\theta_{opt}$: Optimized values of $P_{top\_k}$.

The physics informed data driven model development unit 214 develops one or more physics informed data driven (PIDD) models for each of the one or more selected top m models using the estimated value for the one or more top k unknown parameters. The one or more physics informed data driven (PIDD) models are iteratively trained by minimizing a loss function $\mathcal{L}$, which combines a data-based error ($\mathcal{L}_{data}$($\phi$)) and a physics-based error ($\mathcal{L}_{physics}$($\phi$)). The physics-based error i.e., quantified as a L2 norm of the mathematical equations at collocation points, and the data-based error i.e., the Root Mean Squared Error (RMSE) and/or the Mean Squared Error (MSE). The one or more top *k* unknown parameters are iteratively identified by the inner iteration loop ($iter_k$) in the range of the $T_k$ times, if any of the one or more selected top m models does not meet the pre-defined threshold value for the data-based error ($\mathcal{L}_{data}$($\phi$)), and the physics-based error ($\mathcal{L}_{physics}$($\phi$)). The one or more new set of top m models are selected and continued by the outer iteration loop ($iter_m$) until the range of the $T_m$ times, if any of the one or more selected top m models does not meet the pre-defined threshold value for the data-based error ($\mathcal{L}_{data}$($\phi$)), and the physics-based error ($\mathcal{L}_{physics}$($\phi$)) after iteration of the range of the $T_k$ times. The inner iteration loop ($iter_k$) and the outer iteration loop ($iter_m$) is exited, if any of one or more selected top m models meet the pre-defined threshold value for the data-based error ($\mathcal{L}_{data}$($\phi$)), and the physics-based error ($\mathcal{L}_{physics}$($\phi$)). The one or more trained physics informed data driven (PIDD) models associated with the one or more top *k* unknown parameters associated with the one or more entity are iteratively updated and stored.

Consider, an example of the physics informed data driven (PIDD) models is a physics informed neural network (PINN). The neural network's architecture is subjected to an optimization process, wherein the loss function is minimized. The loss function encapsulates the residues of the physics-based mathematical formulation (M), assessed at multiple points within a computational domain. In an embodiment, if any of the selected top m model does not meet the predetermined threshold values for the physics-based error and the data-based error, an iterative procedure is employed. The iterative process is dedicated to refining both the top *k* parameters, and the top m models, persisting until any of the selected top m model attains a requisite level of accuracy. For example, iterative steps along with a mathematical formulation are as mentioned below:

1. **Initialization:**

a) Select the top *m* models from the data driven model search unit 208.
b) Estimate the top *k* unknown parameters using the parameter attribution determination unit 210A and the physical discrepancy minimizer unit 212.

2. **Physics Informed Neural Network (PINN) Training:**

The neural network architecture is trained by minimizing the loss function $\mathcal{L}$, which combines the data-based error and the physics-based error:

$$\mathcal{L}(\phi) = \alpha \cdot \mathcal{L}_{data}(\phi) + \beta \cdot \mathcal{L}_{physics}(\phi)$$

where:

$\mathcal{L}_{data}$($\phi$) represents the data-based error (e.g., the RMSE, or the MSE).

$\mathcal{L}_{physics}$($\phi$) is the physics-based error, L2 norm of the residues of the governing differential equations.

$\phi$ denotes the parameters of the neural network.
$\alpha$ and $\beta$ are weighting factors.

### 3. **Top m model Parameter Estimation and Optimization:**

Solve for $\phi^*$, the optimal set of parameters, by minimizing the loss function $\mathcal{L}(\phi)$:

$$\phi^* = arg\ min_\phi \mathcal{L}(\phi)$$

The optimization techniques is involved for complexity of the neural network and nature of the differential equations.

### 4. **Iterative Training and Refinement Procedure:**

(a) The outer iteration loop ($iter_m$ in range $T_m$) iterates over the set of top m models. Each model is trained using the physics informed data driven approach, where one or more neural network parameters are optimized by minimizing the combined loss function. The inner iteration loop ($iter_k$ in range $T_k$) identify the top $k$ unknown parameters within each model's training. The parameter attribution determination unit 210A and the physical discrepancy minimizer unit 212 are utilized for updating the parameters and the model's training accuracy is evaluated. If any model satisfies the predefined accuracy criteria, both the inner iteration loop and the outer iteration loop are exited.
(b) After $T_k$ iterations, if there is no physics informed data driven (PIDD) model meets the accuracy criteria, the new set of top m models are selected using the data driven model search unit 206, excluding previous architectures. The outer loop with the new set of models is continued until $T_m$ iterations are completed, or alternatively the new set of models meets the accuracy criteria.

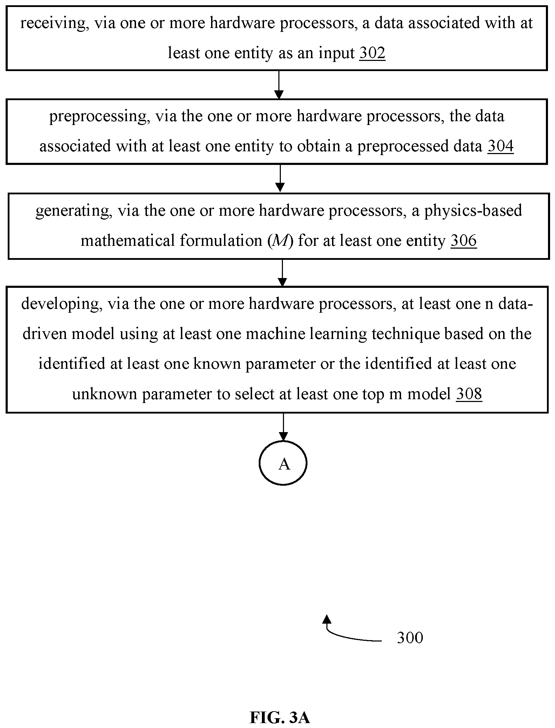

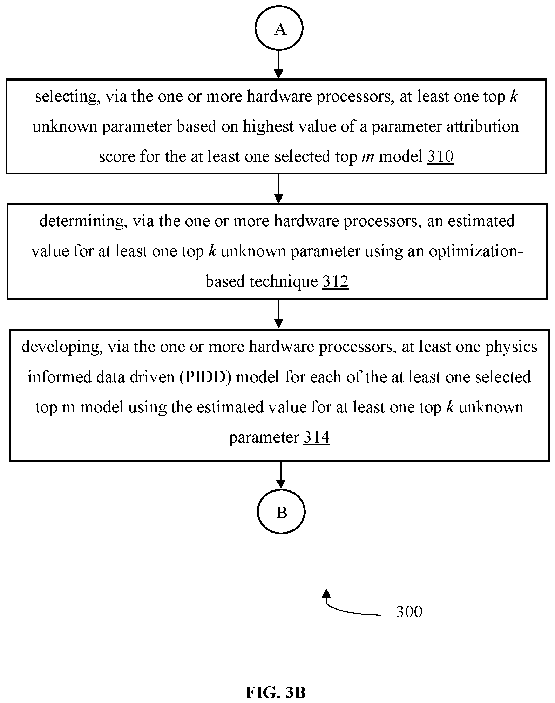

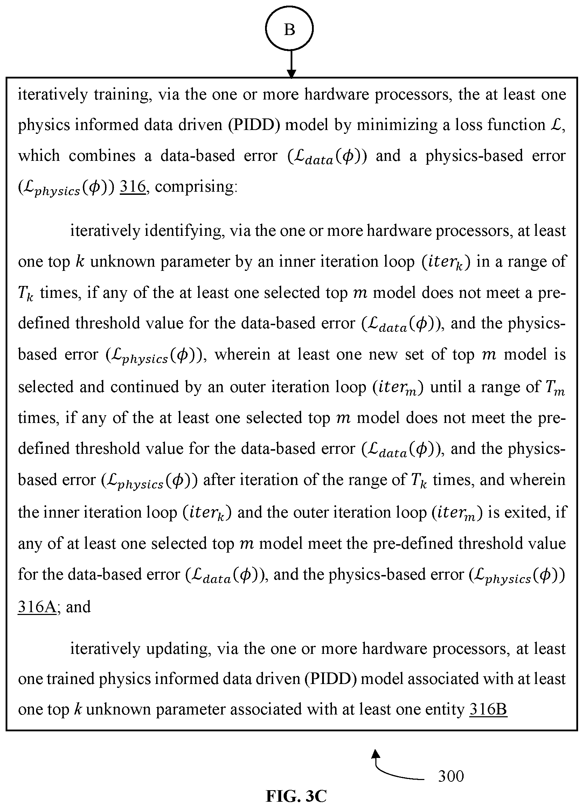

FIG. 3A through FIG. 3C are exemplary flow diagrams illustrating a method 300 of developing one or more physics-informed data-driven models for the industrial digital twins, according to an embodiment of the present disclosure. In an embodiment, the system 100 comprises one or more data storage devices or the memory 104 operatively coupled to the one or more hardware processors 102 and is configured to store instructions for execution of steps of the method by the one or more processors 102. The flow diagram depicted is better understood by way of following explanation/description. The steps of the method 300 of the present disclosure will now be explained with reference to the components of the system 100 as depicted in FIGS. 1 and 2.

At step 302, a data associated with the one or more entity is received as an input (as described in corresponding description of FIG. 2). The data associated with the one or more entity pertains to (i) the sensor measurement data, (ii) the experimental measurement data, (iii) the design data, and (iv) the one or more operational parameters. The one or more entity pertains to the system, or the equipment, or the process. The sensor measurement data pertains to (i) the temperature measurement data, (ii) the pressure measurement data, (iii) the flow measurement data, and (iv) the vibration measurement data. The experimental measurement data pertains to the property or the quality estimation of the fluid or the solid in processing of the one or more entity.

At step 304, the data associated with the one or more entity is preprocessed to obtain the preprocessed data (as described in corresponding description of FIG. 2). The preprocessed data pertains to the cleaned imputed dataset ($\mathcal{D}_{cleaned}$). The data associated with the one or more entity is mapped with the one or more known parameters or the one or more unknown parameters of the one or more entity to generate comparison mappings for the one or more entity using the mapping model. The data associated with the one or more entity is preprocessed to obtain the preprocessed data, includes: (a) the aggregated dataset (D) is obtained at uniform intervals, (b) the outlier data, and the missing data in the aggregated dataset (D) is imputed to obtain the cleaned imputed dataset ($\mathcal{D}_{cleaned}$). The aggregated dataset *(D)* include the outlier data and the missing data which are to be identified by (i) the defining threshold method, or (ii) the statistical method, and (iii) the one or more imputation methods respectively.

At step 306, the physics-based mathematical formulation (*M*) is generated for the one or more entity (as described in corresponding description of FIG. 2). The one or more known parameters and the one or more unknown parameters are identified in the physics-based mathematical formulation (*M*) by the comparison mappings generated for the one or more entity. The one or more parameters are marked as the one or more unknown parameters, if the one or more parameters in the physics-based mathematical formulation (*M*) is not present in the comparison mappings generated for the one or more entity using the mapping model. The physics-based mathematical formulation (*M*) pertains to the set of algebraic equations, or the set of differential equations, or the combination thereof.

At step 308, the one or more n data-driven models is developed using the one or more machine learning techniques based on the one or more identified known parameters or the one or more identified unknown parameters to select one or more top m models (as described in corresponding description of FIG. 2). The one or more n data-driven models are trained to obtain the one or more trained n data-driven models based on the cleaned imputed dataset ( $\mathcal{D}_{cleaned}$ ). The one or more trained n data-driven model are ranked based on the one or more evaluated model performance metrics. The one or more evaluated model performance metrics pertains to the one or more error metrics. The one or more error metrics are computed for each n data-driven model $f_i$, and a rank $R_i$ is assigned using the one or more ranking methods. The one or more top m models are selected based on the corresponding ranks $R_i$.

At step 310, the one or more top $k$ unknown parameters are selected based on the highest value of the parameter attribution score for the one or more selected top $m$ models (as described in corresponding description of FIG. 2). The parameter attribution score is determined based on the degree of deviation or the sensitivity $S(p)$ of the residue of the physics-based mathematical formulation ($M$) for the one or more changes in the one or more unknown parameters. The one or more ranges are estimated for the one or more unknown parameters by querying a reference literature and a database. The sensitivity $S(p)$ is calculated as the partial derivative of the residue with respect to each parameter $p$. The residue of the physics-based mathematical formulation ($M$) is calculated using the one or more data-driven model predictions for each element in the set of parameter combinations ($P\_known$, $P_{unknown}^{sample}$).

At step 312, the estimated value is determined for the one or more top $k$ unknown parameters using the optimization-based technique (as described in corresponding description of FIG. 2). At step 314, the one or more physics informed data driven (PIDD) models are developed for each of the one or more selected top m models using the estimated value for the one or more top $k$ unknown parameters (as described in corresponding description of FIG. 2).

At step 316, the one or more physics informed data driven (PIDD) models are iteratively trained by minimizing a loss function $\mathcal{L}$ , which combines the data-based error ($\mathcal{L}_{data}(\phi)$) and the physics-based error ($\mathcal{L}_{physics}(\phi)$) (as described in corresponding description of FIG. 2). At step 316A, the one or more top $k$ unknown parameters are iteratively identified by the inner iteration loop ($iter_k$) in the range of the $T_k$ times, if any of the one or more selected top m models does not meet the pre-defined threshold value for the data-based error ($\mathcal{L}_{data}(\phi)$), and the physics-based error ($\mathcal{L}_{physics}(\phi)$). The one or more new set of top $m$ models are selected and continued by the outer iteration loop ($iter_m$) until the range of the $T_m$ times, if any of the one or more selected top m models does not meet the pre-defined threshold value for the data-based error ($\mathcal{L}_{data}(\phi)$), and the physics-based error ($\mathcal{L}_{physics}(\phi)$) after iteration of the range of the $T_k$ times. The inner iteration loop ($iter_k$) and the outer iteration loop ($iter_m$) is exited, if any of one or more selected top m models meet the pre-defined threshold value for the data-based error ($\mathcal{L}_{data}(\phi)$), and the physics-based error ($\mathcal{L}_{physics}(\phi)$). At step 316B, the one or more trained physics informed data driven (PIDD) models associated with the one or more top k unknown parameters associated with the one or more entity are iteratively updated.

The embodiments of present disclosure herein addresses unresolved problem of challenges associated with hybrid model development and difficulty in achieving physical consistency in models, especially when process parameters are unknown or require tuning. Embodiments of the present disclosure provide a system and method for developing pretrained models for industrial digital twins. The embodiments of present disclosure develops the physics-informed data-driven models results in models that are accurate. The embodiments of present disclosure provides a technological advancement in the integration of various modules, each addressing specific challenges in developing the physics-informed data-driven models for monitoring, forecasting, prognosis, and diagnosis. The sequential steps, including data pre-processing, formulation of a physics-based model, and the development and selection of data-driven models, ensure a more comprehensive and accurate understanding of the industrial system. Further, a holistic integration of the steps to create the physics-informed data-driven models with enhanced accuracy and efficiency, which may not be evident when considering individual components in isolation. The iterative refinement process contributes to the continuous improvement of the physics-informed data-driven models. The iterative approach allows optimization of one or more parameters and the fine-tuning of the physics-informed data-driven models for optimal performance, ensuring that the physics-informed data-driven models meet predefined error thresholds.

The iterative refinement enhances the adaptability of the physics-informed data-driven models to one or more operational parameters within manufacturing and process plant i.e., thermal power plants, oil and gas refineries, automotive manufacturing, pulp and paper plants, cement plants. The physics-informed data-driven models are meticulously designed to ensure that both the physics-based error and the data-based error are less than predefined thresholds, enhancing their accuracy and reliability. The generated physics-based mathematical formulation which includes one or more parameters that may be unknown or uncertain, provides a robust foundation for subsequent modeling i.e., contributes to the development of more accurate physics-informed data-driven models. The identification and attribution of parameters ensure a clearer understanding of the models which leads to more precise modeling and predictions. Estimating the values of unknown or uncertain parameters to minimize physical discrepancies further refines the physics-informed data-driven models and improves their predictive capabilities. The embodiments of present disclosure provides a high-quality data pre-processing, improved understanding of the physics of the system, selection of top-performing data-driven models, precise parameter attribution and estimation, development of real-time monitoring and diagnosis of models, and continuous iterative refinement for optimization.

The comprehensive pre-processing of the sensor and the experimental measurements, coupled with the design and the operational parameters of the system or the process or the equipment, ensures high-quality data input, thereby leading to an improved foundation for subsequent model development. The selection of the top m models is derived from the data driven model search unit to arrive the physics informed neural network model (PINN). In this context, the neural network's architecture is subjected to the optimization process wherein the loss function is minimized. This function encapsulates the residuals of the mathematical formulation, assessed at multiple points within the computational domain of the formulation, in addition to adhering to boundary constraints. The physics-based mathematical formulation in question comprises a multitude of equations and parameters. The parameters constitute a blend of known and unknown parameters. The most critical k unknown parameters are ascertained through the optimization technique employed in the physical discrepancy minimizer unit, whereas the remaining parameters are sourced from existing literature or databases. Subsequently, the top *m* models are retrained, adhering to the physics informed data driven methodology, and the training accuracy is meticulously evaluated.

The written description describes the subject matter herein to enable any person skilled in the art to make and use the embodiments. The scope of the subject matter embodiments is defined by the claims and may include other modifications that occur to those skilled in the art. Such other modifications are intended to be within the scope of the claims if they have similar elements that do not differ from the literal language of the claims or if they include equivalent elements with insubstantial differences from the literal language of the claims.

It is to be understood that the scope of the protection is extended to such a program and in addition to a computer-readable means having a message therein; such computer-readable storage means contain program-code means for implementation of one or more steps of the method, when the program runs on a server or mobile device or any suitable programmable device. The hardware device can be any kind of device which can be programmed including e.g., any kind of computer like a server or a personal computer, or the like, or any combination thereof. The device may also include means which could be e.g., hardware means like e.g., an application-specific integrated circuit (ASIC), a field-programmable gate array (FPGA), or a combination of hardware and software means, e.g., an ASIC and an FPGA, or at least one microprocessor and at least one memory with software processing components located therein. Thus, the means can include both hardware means, and software means. The method embodiments described herein could be implemented in hardware and software. The device may also include software means. Alternatively, the embodiments may be implemented on different hardware devices, e.g., using a plurality of CPUs.

The embodiments herein can comprise hardware and software elements. The embodiments that are implemented in software include but are not limited to, firmware, resident software, microcode, etc. The functions performed by various components described herein may be implemented in other components or combinations of other components. For the purposes of this description, a computer-usable or computer readable medium can be any apparatus that can comprise, store, communicate, propagate, or transport the program for use by or in connection with the instruction execution system, apparatus, or device.

The illustrated steps are set out to explain the exemplary embodiments shown, and it should be anticipated that ongoing technological development will change the manner in which particular functions are performed. These examples are presented herein for purposes of illustration, and not limitation. Further, the boundaries of the functional building blocks have been arbitrarily defined herein for the convenience of the description. Alternative boundaries can be defined so long as the specified functions and relationships thereof are appropriately performed. Alternatives (including equivalents, extensions, variations, deviations, etc., of those described herein) will be apparent to persons skilled in the relevant art(s) based on the teachings contained herein. Such alternatives fall within the scope of the disclosed embodiments. Also, the words "comprising," "having," "containing," and "including," and other similar forms are intended to be equivalent in meaning and be open ended in that an item or items following any one of these words is not meant to be an exhaustive listing of such item or items, or meant to be limited to only the listed item or items. It must also be noted that as used herein and in the appended claims, the singular forms "a," "an," and "the" include plural references unless the context clearly dictates otherwise.

Furthermore, one or more computer-readable storage media may be utilized in implementing embodiments consistent with the present disclosure. A computer-readable storage medium refers to any type of physical memory on which information or data readable by a processor may be stored. Thus, a computer-readable storage medium may store instructions for execution by one or more processors, including instructions for causing the processor(s) to perform steps or stages consistent with the embodiments described herein. The term "computer-readable medium" should be understood to include tangible items and exclude carrier waves and transient signals, i.e., be non-transitory. Examples include random access memory (RAM), read-only memory (ROM), volatile memory, nonvolatile memory, hard drives, CD ROMs, DVDs, flash drives, disks, and any other known physical storage media.

It is intended that the disclosure and examples be considered as exemplary only, with a true scope of disclosed embodiments being indicated by the following claims.

**Claims**

1. A processor implemented method (300), comprising:

receiving (302), via one or more hardware processors, a data associated with at least one entity as an input, wherein the data associated with at least one entity pertains to (i) a sensor measurement data, (ii) an experimental measurement data, (iii) a design data, and (iv) at least one operational parameter, and wherein at least one entity pertains to a system, or an equipment, or a process;

preprocessing (304), via the one or more hardware processors, the data associated with at least one entity to obtain a preprocessed data, wherein the preprocessed data pertains to a cleaned imputed dataset ($\mathcal{D}_{cleaned}$), wherein the data associated with at least one entity is mapped with at least one known parameter or at least one unknown parameter of at least one entity to generate comparison mappings for at least one entity using a mapping model;

generating (306), via the one or more hardware processors, a physics-based mathematical formulation ($M$) for at least one entity, wherein at least one known parameter and at least one unknown parameter is identified in the physics-based mathematical formulation ($M$) by comparison mappings generated for at least one entity;

developing (308), via the one or more hardware processors, at least one n data-driven model using at least one machine learning technique based on the identified at least one known parameter or the identified at least one unknown parameter to select at least one top m model, wherein at least one n data-driven model is trained to obtain at least one trained n data-driven model based on the cleaned imputed dataset ($\mathcal{D}_{cleaned}$);

selecting (310), via the one or more hardware processors, at least one top $k$ unknown parameter based on highest value of a parameter attribution score for the at least one selected top $m$ model, wherein the parameter attribution score is determined based on a degree of deviation or a sensitivity $S(p)$ of a residue of the physics-based mathematical formulation ($M$) for at least one change in the at least one unknown parameter;

determining (312), via the one or more hardware processors, an estimated value for at least one top k unknown parameter using an optimization-based technique;

developing (314), via the one or more hardware processors, at least one physics informed data driven (PIDD) model for each of the at least one selected top m model using the estimated value for at least one top $k$ unknown parameter; and

iteratively training (316), via the one or more hardware processors, the at least one physics informed data driven (PIDD) model by minimizing a loss function $\mathcal{L}$, which combines a data-based error ($\mathcal{L}_{data}(\phi)$) and a physics-based error ($\mathcal{L}_{physics}(\phi)$), comprising:

iteratively identifying (316A), via the one or more hardware processors, at least one top $k$ unknown parameter by an inner iteration loop ($iter_k$) in a range of $T_k$ times, if any of the at least one selected top m model does not meet a pre-defined threshold value for the data-based error ($\mathcal{L}_{data}(\phi)$), and the physics-based error ($\mathcal{L}_{physics}(\phi)$), wherein at least one new set of top m model is selected and continued by an outer iteration loop ($iter_m$) until a range of $T_m$ times, if any of the at least one selected top m model does not meet the pre-defined threshold value for the data-based error ($\mathcal{L}_{data}(\phi)$), and the physics-based error ($\mathcal{L}_{physics}(\phi)$) after iteration of the range of $T_k$ times, and wherein the inner iteration loop ($iter_k$) and the outer iteration loop ($iter_m$) is exited, if any of at least one selected top $m$ model meet the pre-defined threshold value for the data-based error ($\mathcal{L}_{data}(\phi)$), and the physics-based error ($\mathcal{L}_{physics}(\phi)$); and

iteratively updating (316B), via the one or more hardware processors, at least one trained physics informed data driven (PIDD) model associated with at least one top $k$ unknown parameter associated with at least one entity.

2. The processor implemented method (300) as claimed in claim 1, wherein the sensor measurement data pertains to (i) a temperature measurement data, (ii) a pressure measurement data, (iii) a flow measurement data, and (iv) a vibration measurement data, and wherein the experimental measurement data pertains to a property or a quality estimation of fluid or solid in processing of at least one entity.

3. The processor implemented method (300) as claimed in claim 1, wherein the data associated with at least one entity is preprocessed to obtain the preprocessed data, comprising:

(a) obtaining (304A), via the one or more hardware processors, an aggregated dataset *(D)* at uniform intervals, wherein the aggregated dataset *(D)* comprises an outlier data and a missing data which are to be identified by at least one of (i) a defining threshold method, or (ii) a statistical method, and (iii) one or more imputation methods respectively; and
(b) imputing (304B), via the one or more hardware processors, the outlier data, and the missing data in the aggregated dataset (D) to obtain the cleaned imputed dataset ($\mathcal{D}_{cleaned}$).

4. The processor implemented method (300) as claimed in claim 1, wherein at least one parameter is marked as an unknown parameter, if the at least one parameter in the physics-based mathematical formulation (*M*) is not present in the comparison mappings generated for at least one entity using the mapping model, and wherein the physics-based mathematical formulation (*M*) pertains to a set of algebraic equations, or a set of differential equations, or a combination thereof.

5. The processor implemented method (300) as claimed in claim 1, wherein at least one trained n data-driven model is ranked based on one or more evaluated model performance metrics, wherein the one or more evaluated model performance metrics pertains to one or more error metrics, wherein the one or more error metrics is computed for each n data-driven model $f_i$, and a rank $R_i$ is assigned using one or more ranking methods, and wherein the at least one top m model is selected based on the corresponding ranks $R_i$.

6. The processor implemented method (300) as claimed in claim 1, wherein at least one range is estimated for at least one unknown parameter by querying a reference literature and a database, wherein the sensitivity $S(p)$ is calculated as a partial derivative of the residue with respect to each parameter $p$, and wherein the residue of the physics-based mathematical formulation (*M*) is calculated using at least one data-driven model prediction for each element in a set of parameter combinations (*P_known*, $P_{unknown}^{sample}$).

7. A system (100), comprising:

a memory (104) storing a plurality of instructions;
one or more communication interfaces (106); and
one or more hardware processors (102) coupled to the memory (104) via the one or more communication interfaces (106), wherein the one or more hardware processors (102) are configured by the instructions to:

receive a data associated with at least one entity as an input, wherein the data associated with at least one entity pertains to (i) a sensor measurement data, (ii) an experimental measurement data, (iii) a design data, and (iv) at least one operational parameter, and wherein at least one entity pertains to a system, or an equipment, or a process;
preprocess the data associated with at least one entity to obtain a preprocessed data, wherein the preprocessed data pertains to a cleaned imputed dataset ($\mathcal{D}_{cleaned}$), wherein the data associated with at least one entity is mapped with at least one known parameter or at least one unknown parameter of at least one entity to generate comparison mappings for at least one entity using a mapping model;
generate a physics-based mathematical formulation (*M*) for at least one entity, wherein at least one known parameter and at least one unknown parameter is identified in the physics-based mathematical formulation (*M*) by comparison mappings generated for at least one entity;
develop at least one n data-driven model using at least one machine learning technique based on the identified at least one known parameter or the identified at least one unknown parameter to select at least one top m model, wherein at least one n data-driven model is trained to obtain at least one trained n data-driven model based on the cleaned imputed dataset ($\mathcal{D}_{cleaned}$);
select at least one top k unknown parameter based on highest value of a parameter attribution score for the at least one selected top *m* model, wherein the parameter attribution score is determined based on a degree of deviation or a sensitivity $S(p)$ of a residue of the physics-based mathematical formulation ($M$) for at least one change in the at least one unknown parameter;

determine an estimated value for at least one top $k$ unknown parameter using an optimization-based technique;

develop at least one physics informed data driven (PIDD) model for each of the at least one selected top m model using the estimated value for at least one top $k$ unknown parameter; and

iteratively train the at least one physics informed data driven (PIDD) model by minimizing a loss function $\mathcal{L}$, which combines a data-based error ($\mathcal{L}_{data}(\phi)$) and a physics-based error ($\mathcal{L}_{physics}(\phi)$), comprising:

iteratively identify at least one top $k$ unknown parameter by an inner iteration loop ($iter_k$) in a range of $T_k$ times, if any of the at least one selected top m model does not meet a pre-defined threshold value for the data-based error ($\mathcal{L}_{data}(\phi)$), and the physics-based error ($\mathcal{L}_{physics}(\phi)$), wherein at least one new set of top m model is selected and continued by an outer iteration loop ($iter_m$) until a range of $T_m$ times, if any of the at least one selected top $m$ model does not meet the pre-defined threshold value for the data-based error ($\mathcal{L}_{data}(\phi)$), and the physics-based error ($\mathcal{L}_{physics}(\phi)$) after iteration of the range of $T_k$ times, and wherein the inner iteration loop ($iter_k$) and the outer iteration loop ($iter_m$) is exited, if any of at least one selected top m model meet the pre-defined threshold value for the data-based error ($\mathcal{L}_{data}(\phi)$), and the physics-based error ($\mathcal{L}_{physics}(\phi)$); and

iteratively update at least one trained physics informed data driven (PIDD) model associated with at least one top $k$ unknown parameter associated with at least one entity.

8. The system (100) as claimed in claim 7, wherein the sensor measurement data pertains to (i) a temperature measurement data, (ii) a pressure measurement data, (iii) a flow measurement data, and (iv) a vibration measurement data, and wherein the experimental measurement data pertains to a property or a quality estimation of fluid or solid in processing of at least one entity.

9. The system (100) as claimed in claim 7, wherein the one or more hardware processors (102) are configured by the instructions to preprocess the data associated with at least one entity to obtain the preprocessed data, comprises:

(a) obtain an aggregated dataset (D) at uniform intervals, wherein the aggregated dataset (D) comprises an outlier data and a missing data which are to be identified by at least one of (i) a defining threshold method, or (ii) a statistical method, and (iii) one or more imputation methods respectively; and

(b) impute the outlier data, and the missing data in the aggregated dataset ($\mathcal{D}$) to obtain the cleaned imputed dataset ($\mathcal{D}_{cleaned}$).

10. The system (100) as claimed in claim 7, wherein at least one parameter is marked as an unknown parameter, if the at least one parameter in the physics-based mathematical formulation ($M$) is not present in the comparison mappings generated for at least one entity using the mapping model, and wherein the physics-based mathematical formulation ($M$) pertains to a set of algebraic equations, or a set of differential equations, or a combination thereof.

11. The system (100) as claimed in claim 7, wherein at least one trained n data-driven model is ranked based on one or more evaluated model performance metrics, wherein the one or more evaluated model performance metrics pertains to one or more error metrics, wherein the one or more error metrics is computed for each n data-driven model $f_i$, and a rank $R_i$ is assigned using one or more ranking methods, and wherein the at least one top m model is selected based on the corresponding ranks $R_i$.

12. The system (100) as claimed in claim 7, wherein at least one range is estimated for at least one unknown parameter by querying a reference literature and a database, wherein the sensitivity $S(p)$ is calculated as a partial derivative of the residue with respect to each parameter $p$, and wherein the residue of the physics-based mathematical formulation ($M$) is calculated using at least one data-driven model prediction for each element in a set of parameter combinations ($P\_known$, $P_{unknown}^{sample}$).

**13.** One or more non-transitory machine-readable information storage mediums comprising one or more instructions which when executed by one or more hardware processors cause:

receiving, a data associated with at least one entity as an input, wherein the data associated with at least one entity pertains to (i) a sensor measurement data, (ii) an experimental measurement data, (iii) a design data, and (iv) at least one operational parameter, and wherein at least one entity pertains to a system, or an equipment, or a process;

preprocessing, the data associated with at least one entity to obtain a preprocessed data, wherein the preprocessed data pertains to a cleaned imputed dataset ($\mathcal{D}_{cleaned}$), wherein the data associated with at least one entity is mapped with at least one known parameter or at least one unknown parameter of at least one entity to generate comparison mappings for at least one entity using a mapping model;

generating, a physics-based mathematical formulation ($M$) for at least one entity, wherein at least one known parameter and at least one unknown parameter is identified in the physics-based mathematical formulation ($M$) by comparison mappings generated for at least one entity;

developing, at least one n data-driven model using at least one machine learning technique based on the identified at least one known parameter or the identified at least one unknown parameter to select at least one top m model, wherein at least one n data-driven model is trained to obtain at least one trained n data-driven model based on the cleaned imputed dataset ($\mathcal{D}_{cleaned}$);

selecting, at least one top $k$ unknown parameter based on highest value of a parameter attribution score for the at least one selected top $m$ model, wherein the parameter attribution score is determined based on a degree of deviation or a sensitivity $S(p)$ of a residue of the physics-based mathematical formulation ($M$) for at least one change in the at least one unknown parameter;

determining, an estimated value for at least one top $k$ unknown parameter using an optimization-based technique;

developing, at least one physics informed data driven (PIDD) model for each of the at least one selected top m model using the estimated value for at least one top $k$ unknown parameter; and

iteratively training, the at least one physics informed data driven (PIDD) model by minimizing a loss function $\mathcal{L}$,

which combines a data-based error ($\mathcal{L}_{data}(\phi)$) and a physics-based error ($\mathcal{L}_{physics}(\phi)$), comprising:

iteratively identifying, at least one top k unknown parameter by an inner iteration loop ($iter_k$) in a range of $T_k$ times, if any of the at least one selected top $m$ model does not meet a pre-defined threshold value for the data-based error ($\mathcal{L}_{data}(\phi)$), and the physics-based error ($\mathcal{L}_{physics}(\phi)$), wherein at least one new set of top $m$ model is selected and continued by an outer iteration loop ($iter_m$) until a range of $T_m$ times, if any of the at least one selected top $m$ model does not meet the pre-defined threshold value for the data-based error ($\mathcal{L}_{data}(\phi)$), and the physics-based error ($\mathcal{L}_{physics}(\phi)$) after iteration of the range of $T_k$ times, and wherein the inner iteration loop ($iter_k$) and the outer iteration loop ($iter_m$) is exited, if any of at least one selected top m model meet the pre-defined threshold value for the data-based error ($\mathcal{L}_{data}(\phi)$), and the physics-based error ($\mathcal{L}_{physics}(\phi)$); and

iteratively updating, at least one trained physics informed data driven (PIDD) model associated with at least one top k unknown parameter associated with at least one entity.

**14.** The one or more non-transitory machine readable information of claim 13, wherein the sensor measurement data pertains to (i) a temperature measurement data, (ii) a pressure measurement data, (iii) a flow measurement data, and (iv) a vibration measurement data, and wherein the experimental measurement data pertains to a property or a quality estimation of fluid or solid in processing of at least one entity.

**15.** The one or more non-transitory machine readable information of claim 13, wherein the data associated with at least one entity is preprocessed to obtain the preprocessed data, comprising:

(a) obtaining, an aggregated dataset (D) at uniform intervals, wherein the aggregated dataset (D) comprises an outlier data and a missing data which are to be identified by at least one of (i) a defining threshold method, or (ii) a statistical method, and (iii) one or more imputation methods respectively; and

(b) imputing, the outlier data, and the missing data in the aggregated dataset ($\mathcal{D}$) to obtain the cleaned imputed dataset ($\mathcal{D}_{cleaned}$).

wherein at least one parameter is marked as an unknown parameter, if the at least one parameter in the physics-based mathematical formulation ($M$) is not present in the comparison mappings generated for at least one entity using the mapping model, and wherein the physics-based mathematical formulation ($M$) pertains to a set of algebraic equations, or a set of differential equations, or a combination thereof.

wherein at least one trained n data-driven model is ranked based on one or more evaluated model performance metrics, wherein the one or more evaluated model performance metrics pertains to one or more error metrics, wherein the one or more error metrics is computed for each n data-driven model $f_i$, and a rank $R_i$ is assigned using one or more ranking methods, and wherein the at least one top m model is selected based on the corresponding ranks $R_i$.

wherein at least one range is estimated for at least one unknown parameter by querying a reference literature and a database, wherein the sensitivity $S(p)$ is calculated as a partial derivative of the residue with respect to each parameter $p$, and wherein the residue of the physics-based mathematical formulation ($M$) is calculated using at least one data-driven model prediction for each element in a set of parameter combinations

($P\_known$, $P_{unknown}^{sample}$ ).

FIG. 1

**FIG. 2**

receiving, via one or more hardware processors, a data associated with at least one entity as an input 302

preprocessing, via the one or more hardware processors, the data associated with at least one entity to obtain a preprocessed data 304

generating, via the one or more hardware processors, a physics-based mathematical formulation ($M$) for at least one entity 306

developing, via the one or more hardware processors, at least one n data-driven model using at least one machine learning technique based on the identified at least one known parameter or the identified at least one unknown parameter to select at least one top m model 308

A

300

FIG. 3A

A

selecting, via the one or more hardware processors, at least one top $k$ unknown parameter based on highest value of a parameter attribution score for the at least one selected top $m$ model 310

determining, via the one or more hardware processors, an estimated value for at least one top $k$ unknown parameter using an optimization-based technique 312

developing, via the one or more hardware processors, at least one physics informed data driven (PIDD) model for each of the at least one selected top m model using the estimated value for at least one top $k$ unknown parameter 314

B

300

**FIG. 3B**

$$\text{B}$$

iteratively training, via the one or more hardware processors, the at least one physics informed data driven (PIDD) model by minimizing a loss function $\mathcal{L}$, which combines a data-based error $(\mathcal{L}_{data}(\phi))$ and a physics-based error $(\mathcal{L}_{physics}(\phi))$ 316, comprising:

iteratively identifying, via the one or more hardware processors, at least one top $k$ unknown parameter by an inner iteration loop $(iter_k)$ in a range of $T_k$ times, if any of the at least one selected top $m$ model does not meet a pre-defined threshold value for the data-based error $(\mathcal{L}_{data}(\phi))$, and the physics-based error $(\mathcal{L}_{physics}(\phi))$, wherein at least one new set of top $m$ model is selected and continued by an outer iteration loop $(iter_m)$ until a range of $T_m$ times, if any of the at least one selected top $m$ model does not meet the pre-defined threshold value for the data-based error $(\mathcal{L}_{data}(\phi))$, and the physics-based error $(\mathcal{L}_{physics}(\phi))$ after iteration of the range of $T_k$ times, and wherein the inner iteration loop $(iter_k)$ and the outer iteration loop $(iter_m)$ is exited, if any of at least one selected top $m$ model meet the pre-defined threshold value for the data-based error $(\mathcal{L}_{data}(\phi))$, and the physics-based error $(\mathcal{L}_{physics}(\phi))$ 316A; and

iteratively updating, via the one or more hardware processors, at least one trained physics informed data driven (PIDD) model associated with at least one top $k$ unknown parameter associated with at least one entity 316B

300

**FIG. 3C**

Europäisches Patentamt

European Patent Office

Office européen des brevets

# EUROPEAN SEARCH REPORT

**Application Number**

EP 25 16 3170

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2020/311326 A1 (KOCHAR ROHIT [IN] ET AL) 1 October 2020 (2020-10-01) * the whole document * | 1-15 | INV. G05B13/02 |
| A | BRADLEY WILLIAM ET AL: "Perspectives on the integration between first-principles and data-driven modeling", COMPUTERS & CHEMICAL ENGINEERING, PERGAMON PRESS, OXFORD, GB, vol. 166, 22 June 2022 (2022-06-22), XP087186817, ISSN: 0098-1354, DOI: 10.1016/J.COMPCHEMENG.2022.107898 [retrieved on 2022-06-22] * the whole document * | 1-15 | |
| A | US 2022/147672 A1 (NISTALA SRI HARSHA [IN] ET AL) 12 May 2022 (2022-05-12) * the whole document * | 1-15 | |
| A | US 2023/370023 A1 (YU TAO [US] ET AL) 16 November 2023 (2023-11-16) * the whole document * | 1-15 | **TECHNICAL FIELDS SEARCHED (IPC)** G05B G06Q |

The present search report has been drawn up for all claims

| Place of search | Date of completion of the search | Examiner |
|---|---|---|
| The Hague | 1 September 2025 | José Luis Meseguer |

EPO FORM 1503 03.82 (P04C01)

## ANNEX TO THE EUROPEAN SEARCH REPORT
## ON EUROPEAN PATENT APPLICATION NO.

EP 25 16 3170

This annex lists the patent family members relating to the patent documents cited in the above-mentioned European search report.
The members are as contained in the European Patent Office EDP file on
The European Patent Office is in no way liable for these particulars which are merely given for the purpose of information.

01-09-2025

| Patent document cited in search report | Publication date | Patent family member(s) | | Publication date |
|---|---|---|---|---|
| US 2020311326 A1 | 01-10-2020 | US | 2020311326 A1 | 01-10-2020 |
| | | US | 2025094677 A1 | 20-03-2025 |
| | | WO | 2020202189 A1 | 08-10-2020 |
| US 2022147672 A1 | 12-05-2022 | EP | 3969966 A2 | 23-03-2022 |
| | | US | 2022147672 A1 | 12-05-2022 |
| | | WO | 2020234899 A2 | 26-11-2020 |
| US 2023370023 A1 | 16-11-2023 | EP | 4277127 A1 | 15-11-2023 |
| | | US | 2023370023 A1 | 16-11-2023 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- IN 202421018772